# DEMANDE DE BREVET EUROPEEN

(11) **EP 4 202 981 A1**
(43) Date de publication de la demande: **28.06.2023**
(21) Numéro de dépôt: 22213314.2
(22) Date de dépôt: 14.12.2022
(51) Int. Cl.: H01L 21/60, H01L 21/683, H01L 21/02

(54) **PROCEDE D'ASSEMBLAGE PAR COLLAGE DIRECT DE COMPOSANTS ELECTRONIQUES**

(30) Priorité: 23.12.2021 FR 2114441
(71) Demandeur: Commissariat à l'énergie atomique et aux énergies alternatives, 75015 Paris (FR)
(72) Inventeur: FOURNEL, Frank, 38054 GRENOBLE CEDEX 09 (FR); MORALES, Christophe, 38054 GRENOBLE CEDEX 09 (FR); SANCHEZ, Loïc, 38054 GRENOBLE CEDEX 09 (FR); MONTMAYEUL, Brigitte, 38054 GRENOBLE CEDEX 09 (FR)
(74) Mandataire: Cabinet Beaumont

(57) **Abrégé**

La présente description concerne un procédé de préparation d'une première surface (320a, 310a) d'un composant électronique (320, 310), ladite première surface étant destinée à être collée à un autre composant électronique (310, 320) par un collage direct et ladite première surface ayant subi préalablement un traitement de surface sous une atmosphère comprenant de l'azote, par exemple un traitement sous plasma azote ou un traitement UV à l'ozone, le procédé de préparation comprenant :
- la mise en contact de ladite première surface avec une solution aqueuse comprenant au moins 90% d'eau, pendant une durée de mise en contact supérieure ou égale à 30 minutes ; puis
- le séchage de ladite première surface.

## Description

### Domaine technique

La présente description concerne de façon générale le collage de composants électroniques entre eux, plus particulièrement de composants microélectroniques. La présente description concerne en particulier le collage direct de composants microélectroniques.

### Technique antérieure

Le collage direct, également appelé "collage moléculaire", est une technique d'assemblage de composants microélectroniques permettant de solidariser deux surfaces, une pour chaque composant microélectronique, par adhésion moléculaire via une mise en contact direct de ces deux surfaces, sans faire appel à un matériau de collage.

Il est possible d'assembler par collage direct deux plaques entre elles, selon une technique dite "plaque à plaque" ("Wafer-to-Wafer" en anglais), par exemple deux plaques de matériaux différents et/ou de dimensions différentes.

Il est également possible d'assembler par collage direct une puce sur un substrat (par exemple une plaque), selon une technique dite "puce à plaque" ("Die-to-Wafer" en anglais). Cette technique vise à reporter une puce sur un substrat, chacun pouvant être préalablement fonctionnalisé, c'est-à-dire muni de composants électroniques. Une extension de cette technique est le collage direct de plusieurs puces sur un substrat, simultanément ou non.

Dans le cadre du collage direct d'une puce sur un substrat, la puce à coller peut être positionnée de manière adaptée contre le substrat en utilisant une technique de collage direct assisté par capillarité, en utilisant un fluide, généralement de l'eau. Le fluide peut être déposé sur la puce ou sur le substrat. On retrouve cette technique de collage dans la technique de collage dit "auto-aligné" où l'on cherche en plus à garantir un alignement précis de la puce vis-à-vis du substrat.

Cette technique de collage direct par capillarité peut en particulier être appliquée pour un collage direct de plusieurs puces sur un substrat, en particulier pour coller simultanément plusieurs puces sur un substrat, mais cette technique est alors rendue plus complexe, et il peut être observé des défauts de collage de certaines puces sur le substrat.

### Résumé de l'invention

Il existe un besoin d'améliorer la technique de collage direct de puces sur un substrat, notamment la technique de collage direct assisté par capillarité, et plus généralement la technique de collage direct de composants électroniques entre eux.

Un mode de réalisation pallie tout ou partie des inconvénients des techniques de collage direct connues.

Un mode de réalisation prévoit un procédé de préparation d'une première surface d'un composant électronique, ladite première surface étant destinée à être collée sur un autre composant électronique par un collage direct et ladite première surface ayant subi préalablement un traitement de surface sous une atmosphère comprenant de l'azote, par exemple un traitement sous plasma azote ou un traitement UV à l'ozone, le procédé de préparation comprenant :
- la mise en contact de ladite première surface avec une solution aqueuse comprenant au moins 90% d'eau, pendant une durée de mise en contact supérieure ou égale à 30 minutes ; puis
- le séchage de ladite première surface.

Selon un mode de réalisation avantageux, la durée de mise en contact est strictement supérieure à 30 minutes, par exemple supérieure ou égale à 40 minutes, voire supérieure ou égale à 50 minutes. Par exemple, la durée de mise en contact est égale à environ 50 minutes.

Selon un mode de réalisation, la durée de mise en contact est strictement supérieure à 30 minutes et inférieure ou égale à 120 minutes, par exemple avantageusement supérieure ou égale à 40 minutes et inférieure ou égale à 120 minutes, voire supérieure ou égale à 40 minutes et inférieure ou égale à 60 minutes.

Selon un mode de réalisation, la solution aqueuse est de l'eau désionisée, ou une solution d'eau désionisée à laquelle une base ou un acide a été ajouté (e) avec une concentration inférieure à 10%, de préférence inférieure à 1%, ou une solution d'eau désionisée à laquelle un composé amphotère a été ajouté, par exemple de l'eau oxygénée.

Selon un mode de réalisation, la mise en contact avec la solution aqueuse comprend un trempage dans ladite solution aqueuse.

Selon un mode de réalisation, la durée de mise en contact est supérieure ou égale à une heure.

Selon un mode de réalisation, la mise en contact avec la solution aqueuse est réalisée à une température supérieure à la température ambiante et inférieure à 100°C, de préférence inférieure à 80°C.

Selon un mode de réalisation, le séchage est un séchage par centrifugation ou utilise un sécheur.

Selon un mode de réalisation, le composant électronique est une puce électronique.

Selon un mode de réalisation, le composant électronique est un substrat, par exemple une plaque.

Selon un mode de réalisation, le procédé de préparation comprend, préalablement à l'étape de mise en contact avec la solution aqueuse, une étape de traitement de la première surface sous une atmosphère comprenant de l'azote, par exemple avec un plasma à l'azote ou un traitement UV à l'ozone.

Un mode de réalisation prévoit un procédé d'assemblage par collage direct d'une première surface d'au moins un premier composant électronique et d'une première surface d'un deuxième composant électronique, le procédé d'assemblage comprenant une étape de préparation d'au moins une parmi la première surface du au moins un premier composant électronique et la première surface du deuxième composant électronique selon le procédé de préparation d'un mode de réalisation, préalablement au collage direct.

Selon un mode de réalisation, le collage direct est un collage direct assisté par capillarité.

Selon un mode de réalisation, le collage direct est obtenu par évaporation d'un liquide, de préférence de l'eau, disposé entre la première surface du au moins un premier composant électronique et la première surface du deuxième composant électronique.

Selon un mode de réalisation, il y a une pluralité dudit au moins un premier composant électronique, lesdits premiers composants électroniques étant des puces électroniques, et le deuxième composant étant un substrat, par exemple une plaque.

Selon un mode de réalisation, le procédé d'assemblage comprend :
- une étape de positionnement des puces sur un support de puces, ledit support étant adapté à maintenir les puces de manière individualisée en vue de leur assemblage au substrat ;
- une étape de formation d'un film de liquide, par exemple un film d'eau désionisée, sur la première surface du substrat ;
- une étape de mise en contact des puces avec le film de liquide, ladite mise en contact provoquant une attraction desdites puces vers le substrat ;
- une étape d'évaporation du film de liquide de manière à coller les puces sur le substrat par collage direct ;
l'étape de préparation comprenant la préparation, par exemple selon le procédé de préparation décrit ci-dessus, des premières surfaces des puces, et étant réalisée après l'étape de positionnement, et avant l'étape de mise en contact avec le film de liquide.

Selon un mode de réalisation, la mise en contact des puces avec le film de liquide est assurée en rapprochant le substrat et le support de puces.

Selon un mode de réalisation, le procédé d'assemblage comprend l'utilisation d'au moins une butée agencée entre le substrat et le support de puces pour stopper le rapprochement qui assure la mise en contact des puces avec le film de liquide.

Selon un mode de réalisation, le support de puces comporte des cavités, chaque puce étant positionnée dans une cavité, la première surface de ladite puce dépassant de ladite cavité, et le procédé d'assemblage comporte une étape de retrait des puces des cavités, ladite étape de retrait étant mise en œuvre après la mise en contact des puces avec le film de liquide et avant le collage des puces sur le substrat.

Selon un mode de réalisation, le support de puces comporte un film adhésif sur lequel les puces sont collées, ledit film adhésif présentant une élasticité telle qu'il se déforme au cours de l'étape d'évaporation, et le procédé d'assemblage comprend, après le collage des puces sur le substrat, une étape de retrait du film adhésif.

Selon un mode de réalisation particulier, l'étape de retrait du film adhésif comporte une étape de chauffage dudit film adhésif ou une étape d'exposition dudit film adhésif à un rayonnement ultraviolet.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente schématiquement des puces collées à un substrat via un procédé d'assemblage par collage direct ;
la figure 2 est une vue au microscope acoustique de puces sur un substrat après un procédé d'assemblage par collage direct assisté par capillarité ;
la figure 3A, la figure 3B, la figure 3C et la figure 3D sont des vues en coupe représentant des étapes d'un procédé d'assemblage par collage direct assisté par capillarité selon un premier mode de réalisation ;
la figure 4A, la figure 4B, la figure 4C, la figure 4D et la figure 4E sont des vues en coupe représentant des étapes d'un procédé d'assemblage par collage direct assisté par capillarité selon un deuxième mode de réalisation ;
la figure 5 est une vue au microscope acoustique de puces sur un substrat après un procédé d'assemblage par collage direct assisté par capillarité selon un mode de réalisation ;
la figure 6A et la figure 6B représentent des résultats de mesure d'azote par spectrométrie XPS de surfaces traitées par un plasma à l'azote, l'une n'étant pas post-traitée, et l'autre étant post-traitée par trempage dans une solution aqueuse.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les étapes de préparation de puces individuelles et/ou d'un substrat ne sont pas détaillées, et les contacts électriques entre composants électroniques ne sont pas représentés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

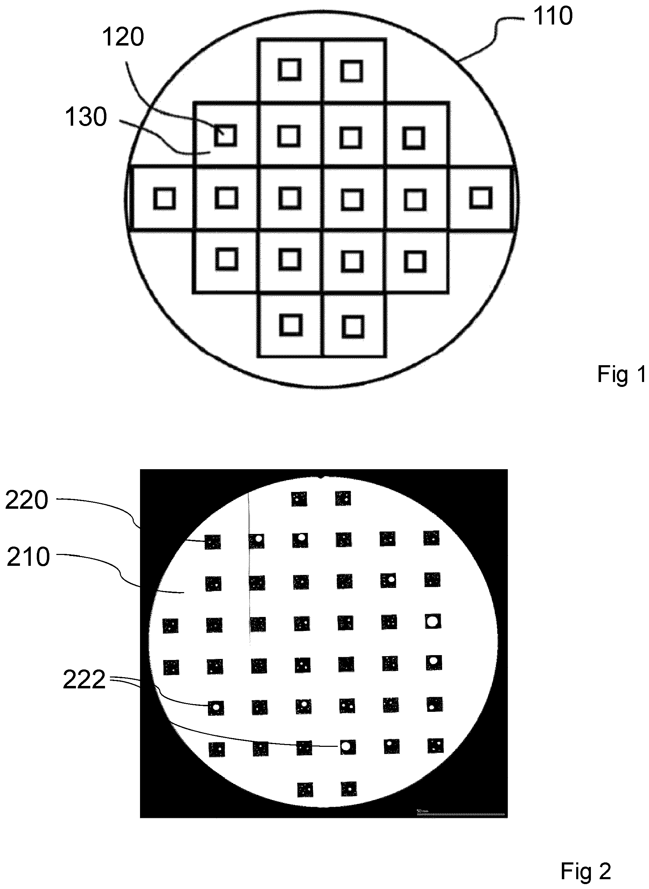

Un procédé d'assemblage de plusieurs puces 120 sur un substrat 110 par collage direct permet par exemple d'obtenir la structure visible en figure 1 où les puces 120 sont collées sur le substrat 110.

Les puces 120 ("die" en anglais) peuvent avoir subi des étapes technologiques de la microélectronique, par exemple : dépôt de matériau, photolithographie, et/ou gravure. Les puces 120 peuvent comporter du, ou être à base de, silicium (Si), phosphure d'indium (InP), arséniure de gallium (GaAs), carbure de silicium (SiC), germanium (Ge), saphir. Elles peuvent présenter en surface des couches de matériaux comme de la silice, du nitrure de silicium, des métaux comme le cuivre ou le titane, et toutes autres couches connues de la microélectronique, comme une couche de dioxyde d'hafnium (HfO₂), de matériau organosilicié (SiOC), de nitrure d'aluminium (AlN) ou de l'alumine (Al₂O₃). Les puces 120 peuvent être des puces électroniques.

Le substrat 110 peut comporter des composants électroniques 130 à relier, par exemple à connecter, de préférence électriquement, aux puces 120 par collage direct de ces puces sur le substrat 110.

Le substrat 110 peut être une plaquette, par exemple une plaquette de silicium, à laquelle des étapes technologiques ont été appliquées pour former des composants électroniques 130. Le substrat 110 comportant les composants électroniques 130 est aussi appelé substrat fonctionnalisé.

La figure 1 illustre notamment les puces 120 collées par collage direct au substrat 110 comportant les composants électroniques 130, une puce étant collée par exemple à un composant électronique 130.

Une première technique pour assembler les puces sur le substrat par collage direct assisté par capillarité consiste à mettre une goutte d'eau sur chaque puce et ensuite à positionner l'ensemble puce-goutte sur le substrat, la goutte en contact avec le substrat. Après le séchage de l'eau, chaque puce se retrouve collée par collage direct sur le substrat.

Une autre technique consiste à mettre un film d'eau sur le substrat et à positionner les puces sur ce film d'eau. Après séchage du film d'eau, les puces se retrouvent collées par collage direct sur le substrat.

Un exemple de procédé de collage de puces sur un substrat selon cette autre technique est par exemple décrit dans la publication « Collective Die Direct Bonding for Photonic on Silicon » (L. Sanchez, F. Fournel, B. Montmayeul, L. Bally, B. Szelag, and L. Adelmini, ECS Trans. 86, 223 (2018)).

Selon un exemple, un film de liquide, par exemple de l'eau, est déposé sur une première surface d'un substrat, et les puces sont installées sur un support de puces. Ce support a l'avantage de pouvoir présenter simultanément plusieurs puces pour leur assemblage sur le substrat. Ensuite, les puces sur leur support sont mises en contact avec le film de liquide, provoquant une attraction par capillarité des puces vers le substrat. Puis, le film de liquide est éliminé par évaporation, et les puces se retrouvent collées sur le substrat. L'assemblage peut subir un traitement thermique, ou recuit thermique, afin notamment de renforcer l'énergie de collage. Ce recuit est avantageusement réalisé à basse température, typiquement inférieure ou égale à 400°C pour ne pas dégrader l'assemblage et notamment ses propriétés électriques.

Les surfaces du substrat et/ou des puces destinées à être assemblées l'une à l'autre peuvent être préalablement préparées de manière à éliminer la contamination organique sur ces surfaces et/ou augmenter l'hydrophilie de ces surfaces, par exemple par un traitement plasma à l'air ou à l'azote (N₂) ou un traitement UV-Ozone sous air (UV pour UltraViolet). Un tel traitement peut permettre d'augmenter l'énergie de collage obtenue après l'étape de recuit. Il est précisé qu'un traitement UV-Ozone sous air consiste en une exposition de la surface à traiter à un rayonnement UV en présence d'air, ce qui crée de l'ozone.

Cependant, il a été observé une très forte défectivité à l'interface de collage des puces sur le substrat après l'élimination du film ou de la goutte de liquide, lorsque les surfaces du substrat et/ou des puces destinées à être assemblées l'une à l'autre ont reçu un tel traitement plasma à l'air ou à l'azote, ou un tel traitement UV-Ozone sous air préalable. Ceci est illustré par un exemple en figure 2, illustrant des puces 220 (carrés noirs) sur un substrat 210 (rond blanc), les points blancs 222 au niveau des puces correspondant à des défauts de collage.

Les inventeurs proposent un procédé d'assemblage par collage direct permettant de répondre aux besoins d'amélioration décrits précédemment, et de pallier tout ou partie des inconvénients des procédés d'assemblage décrits précédemment. En particulier, les inventeurs proposent un procédé de préparation de composants électroniques et un procédé d'assemblage par collage direct desdits composants électroniques entre eux, par exemple d'une ou plusieurs puces sur un substrat, permettant d'améliorer le collage desdits composants électroniques entre eux.

Des modes de réalisation de systèmes vont être décrits ci-après. Les modes de réalisation décrits sont non limitatifs et diverses variantes apparaîtront à la personne du métier à partir des indications de la présente description.

Dans la description qui suit, on décrit des procédés d'assemblage par collage direct de plusieurs puces sur un substrat. D'autres procédés d'assemblage par collage direct de plusieurs puces sur un substrat peuvent être envisagés. De même, d'autres procédés d'assemblage par collage direct d'une puce sur un substrat, ou plus généralement de plusieurs composants électroniques entre eux, peuvent être envisagés par la personne du métier.

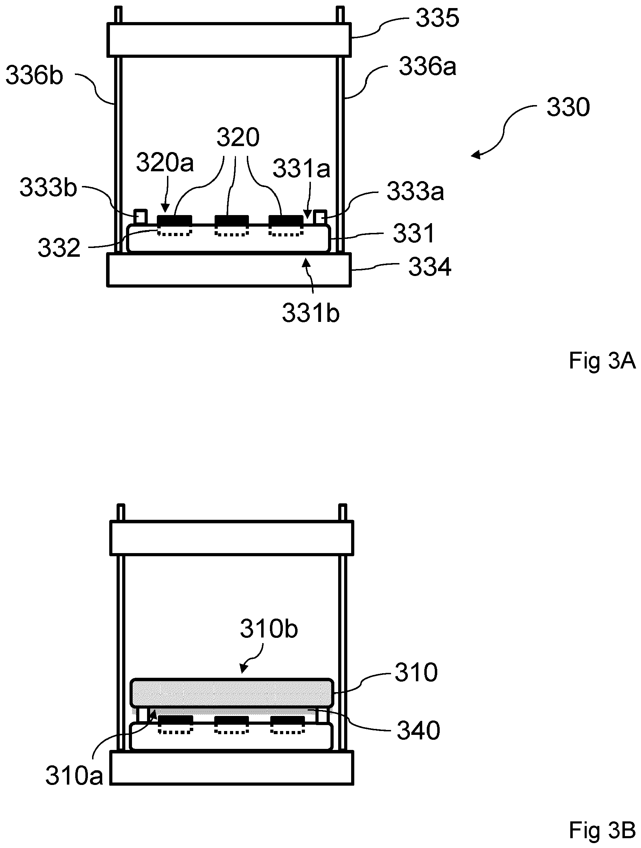

Les figures 3A à 3D sont des vues en coupe représentant des étapes d'un procédé d'assemblage par collage direct assisté par capillarité selon un premier mode de réalisation.

Ce procédé met en œuvre un système d'assemblage 330 comprenant :
- un support 331 de puces 320, ledit support de puces comportant des cavités 332 formées à partir d'une première surface 331a dudit support et représentées chacune schématiquement en pointillés, chaque cavité étant adaptée à contenir une puce 320 de manière à ce qu'une portion supérieure de ladite puce dépasse de ladite cavité ;
- optionnellement, des butées 333a, 333b (ou cales) adaptées à être positionnées sur la première surface 331a du support 331 ; de telles butées visent à stopper le rapprochement entre les puces 320 lorsqu'elles sont positionnées dans les cavités 332 et le substrat 310, comme décrit plus après ; et
- un dispositif d'assemblage comprenant un élément de support inférieur 334 et un élément de support supérieur 335 déplaçable par rapport à l'élément de support inférieur 334, par exemple en utilisant des guides 336a, 336b ; les éléments de support inférieur et supérieur peuvent aussi être appelés chacun "chuck" ; l'élément de support supérieur est de préférence aspirant.

Le support 331 peut être une poignée mécanique, par exemple formée par une plaque rigide. Une telle poignée mécanique peut comprendre, par exemple être composée de ou être revêtue de, silicium, dioxyde de silicium, saphir, germanium, carbure de silicium, alumine ou nitrure de silicium.

Les cavités 332 formées dans le support 331 peuvent être de formes et de géométries différentes, par exemple, lorsque les puces sont de formes et de géométries différentes. En particulier, la profondeur d'une cavité est adaptée à la puce qu'elle doit recevoir et notamment à son épaisseur, et est déterminée de manière à ce qu'une portion supérieure de ladite puce dépasse de ladite cavité.

Des étapes du procédé sont décrites ci-après d'abord en lien avec la figure 3A.

Les puces 320 sont placées dans les cavités 332 du support 331, l'épaisseur des puces 320 étant dans la direction de la profondeur des cavités 332.

Les puces 320 peuvent être placées dans les cavités 332 au moyen d'un dispositif de manipulation de puces, aussi appelé "pick and place" en anglais, en évitant de toucher les faces des puces allant être collées par collage direct au substrat 310.

Une fois les puces 320 en position dans les cavités 332, il est réalisé une étape de traitement de surface desdites puces, par exemple un traitement plasma N₂ ou un traitement à l'ozone sous air. Le traitement de surface de chaque puce 320 est réalisé au moins sur une première surface 320a de ladite puce destinée à être assemblée au substrat 310 (ladite première surface étant comprise dans la portion supérieure de la puce qui dépasse de la cavité).

Ensuite, il est réalisé un post-traitement des puces 320 comprenant une étape de mise en contact desdites puces avec, par exemple de trempage dans, une solution aqueuse comprenant au moins 90% d'eau, pendant au moins 30 minutes et de préférence au moins 1 heure, suivie d'une étape de séchage desdites puces, par exemple par centrifugation. La mise en contact avec la solution aqueuse est réalisée au moins sur les premières surfaces 320a (traitées) des puces.

L'ensemble des étapes de traitement de surface et de post-traitement peut être désigné par "étape de préparation" ou "procédé de préparation" (des puces et/ou du substrat, plus généralement d'un composant électronique destiné à être assemblé à un autre composant électronique). Il est à noter que le post-traitement peut être réalisé pendant le traitement de surface, par exemple après un traitement de surface mettant en œuvre de l'azote et avant un autre traitement de surface ne mettant pas en œuvre de l'azote.

Après les étapes de traitement de surface et de post-traitement des puces, les butées 333a, 333b peuvent être disposées sur des bords de la première surface 331a du support 331, lesdites puces 320 étant entre lesdites butées.

Le support 331, muni des puces 320 et des butées 333a, 333b, est positionné, du côté de sa deuxième surface 331b, sur l'élément de support inférieur 334. De préférence, l'élément de support inférieur 334 est sensiblement horizontal lors du positionnement du support 331, et maintenu sensiblement horizontal ensuite, typiquement à maximum plus ou moins 1° et préférentiellement à maximum plus ou moins 0,1°.

Le substrat 310 peut être préparé suivant le même protocole de préparation que pour les puces 320, à savoir une étape de traitement de surface et un post-traitement, a minima sur une première surface 310a dudit substrat destinée à être assemblée avec les puces 320.

Des étapes suivantes du procédé sont décrites ci-après en lien avec la figure 3B.

Un film de liquide 340, par exemple un film d'eau, est formé sur la première surface 310a du substrat 310, par exemple par dépôt du liquide puis centrifugation. L'épaisseur du film de liquide est par exemple comprise entre 10 et 100 µm.

Le substrat 310 est ensuite retourné et positionné au-dessus du support 331 en mettant les puces 320 en contact avec le film de liquide 340. Le cas échéant, ce positionnement correspond à poser le substrat 310 sur les butées 333a, 333b déjà positionnées sur le support 331. De préférence, lors du rapprochement du support 331 et du substrat 310, ledit support et ledit substrat sont chacun maintenus sensiblement horizontaux, typiquement à maximum plus ou moins 1° et préférentiellement à maximum plus ou moins 0,1°.

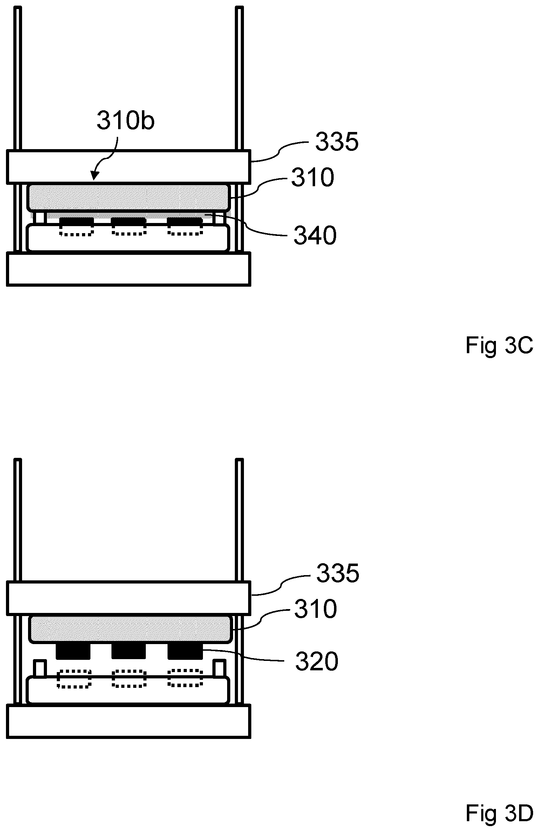

Ensuite, comme illustré en figure 3C, l'élément de support supérieur 335 aspirant est descendu contre la deuxième surface 310b du substrat 310.

Puis, une fois le substrat 310 aspiré par l'élément de support supérieur 335, ledit élément de support supérieur est relevé de manière à soulever le substrat 310, et ce, de préférence en conservant l'horizontalité dudit substrat, pour éviter le glissement du film de liquide 340 pendant son évaporation, glissement qui pourrait avoir pour effet de désaligner les puces 320 à coller au substrat 310. En effet, le soulèvement du substrat permettant de retirer les puces des cavités 332, lesdites puces ne sont alors maintenues que par le film de liquide.

Puis, comme illustré en figure 3D, le film de liquide 340 est évaporé. Dès que le temps nécessaire à l'évaporation du film de liquide est passé, les puces 320 se retrouvent assemblées par collage direct sur le substrat 310, et la structure substrat-puces peut être retirée du système 330.

De manière connue de la personne du métier, cette structure substrat-puces est alors recuite, par exemple à 200°C ou 400°C, voire plus.

Il est à présent donné un exemple particulier du premier mode de réalisation.

Avant d'être placées dans les cavités, les puces 320 sont préparées ainsi : il est mesuré l'épaisseur de trois plaques de phosphure d'indium (InP) de 50 mm de diamètre qui vont être découpées pour former les puces 320. Les épaisseurs mesurées de ces trois plaques sont toutes comprises entre 325 µm et 375 µm. Les puces 320 sont formées par découpe des trois plaques d'InP. Ces puces 320 présentent chacune, orthogonalement à leur épaisseur, un profil carré de 10 mm par 10 mm.

Le support (poignée mécanique) est une plaque en forme de disque, de diamètre égal à environ 200 mm. Les cavités 332 présentent chacune une profondeur d'environ 250 µm et comportent chacune une paroi latérale s'étendant depuis le fond de la cavité vers l'ouverture de la cavité 332, chaque cavité présentant orthogonalement à sa profondeur un profil carré de 10,2 mm par 10,2 mm.

Les butées 333a, 333b sont par exemple en silicium. Si on les positionne dans des cavités, elles ont chacune une épaisseur d'environ 50 µm supérieure à l'épaisseur des puces 320, par exemple comprise entre environ 375 µm et 425 µm. Si on les positionne sur la surface 331a du support 331, alors elles doivent être plus fines que les puces 320 d'environ 250 µm (correspondant sensiblement à l'épaisseur des cavités 332).

Le dispositif de manipulation des puces 320 peut comporter : un outil pyramidal qui ne touche que les bords de chaque puce saisie, un outil formant une pince saisissant chaque puce par leurs bords latéraux, ou un outil utilisant l'effet Venturi pour saisir chaque puce.

Le traitement de surface (des puces et/ou du substrat) comprend un traitement plasma N₂ de 20 secondes pour retirer la contamination hydrocarbure des surfaces destinées à être assemblées. Le traitement de surface peut aussi comprendre un retrait de la contamination particulaire par un traitement mégasonique des puces et/ou du substrat. Ce traitement mégasonique peut être réalisé en utilisant des mégasons et une solution d'eau désionisée additionnée d'ammoniaque à 1%, par exemple avec une fréquence de 1MHz et une puissance de 1W/cm², un tel traitement mégasonique étant connu de la personne du métier comme le montre par exemple le document «Innovative megasonic cleaning technology evaluated through direct wafer bonding.» de F. Fournel et al., publié dans ECS Transactions, 33 (4) 495-500 (2010).

Le post-traitement des puces 320 et/ou du substrat 310 comprend une étape de trempage dans de l'eau désionisée pendant une heure, suivie d'une étape de séchage par centrifugation à 2000 tours/min pendant 45 secondes.

Pour former le film de liquide 340, après dépôt du liquide sur la première surface 310a du substrat 310, une étape de centrifugation de 30 tours/minute pendant 20 secondes est mise en oeuvre pour former le film liquide 340, de sorte à ne laisser sur ladite première surface dudit substrat qu'un film de liquide d'épaisseur comprise entre environ 50 µm et 75 µm, plus largement une épaisseur compatible pour venir au contact avec les puces 320 lorsque le support 331 et le substrat 310 sont séparés, le cas échéant, par les butées 333a, 333b.

Le film de liquide 340 est un film d'eau désionisée. L'eau désionisée présente l'avantage de ne pas laisser de résidus après évaporation.

Pour relever le substrat 310, l'élément de support 335 est remonté d'environ 300 µm.

L'évaporation du film de liquide 340 est réalisée entre 30 minutes et 6 heures, par exemple 4 heures, à pression et température ambiantes sous 45% d'humidité.

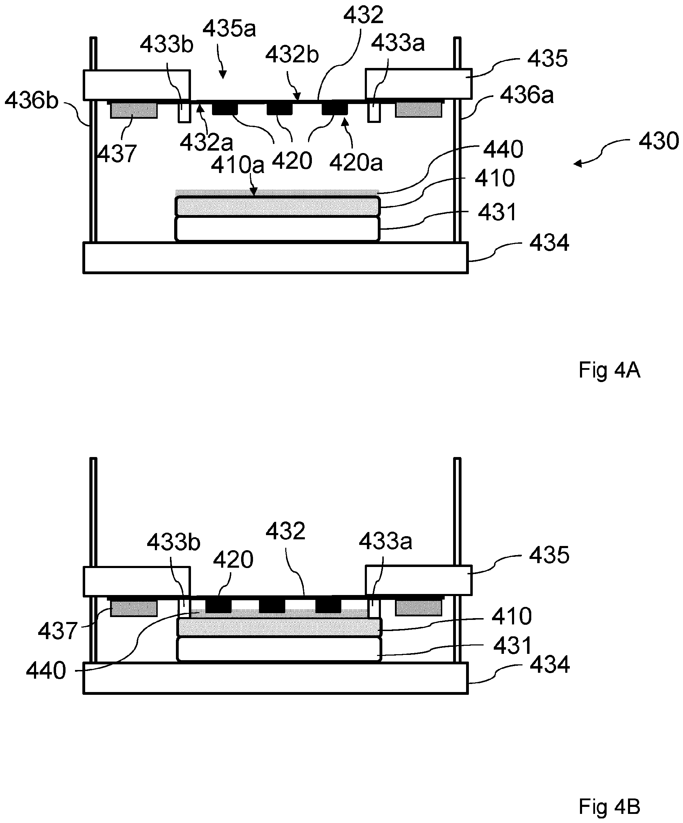

Les figures 4A à 4E sont des vues en coupe représentant des étapes d'un procédé de collage direct assisté par capillarité selon un deuxième mode de réalisation.

Ce procédé met en œuvre un système d'assemblage 430 comprenant :
- un film adhésif 432 (formant support de puces) adapté à faire maintenir par adhésion des puces 420 sur une première surface 432a dudit film destinée à être en regard avec le substrat 410 en vue de l'assemblage desdites puces audit substrat, ledit film adhésif présentant une élasticité telle qu'il peut se déformer pour permettre aux puces de se rapprocher du substrat lors d'une étape d'évaporation d'un film liquide sur le substrat, comme décrit plus après ;
- un élément de support supérieur 435 comportant une ouverture 435a en partie centrale, et adapté à être solidarisé avec deux portions d'extrémités du film adhésif 432 du côté de la deuxième surface 432b dudit film ;
- un cadre 437 (ou anneau) adapté à être solidarisé avec deux portions d'extrémités du film adhésif 432 par adhésion sur la première surface 432a dudit film ;
- optionnellement, des butées 433a, 433b (ou cales) adaptées à être positionnées sur la première surface 432a du film adhésif 432, afin de stopper le rapprochement qui assure la mise en contact des puces 420 avec le substrat 410, plus précisément avec un film liquide 440 formé sur le substrat, comme décrit plus après ;
- un élément de support inférieur 434 ;
   l'élément de support supérieur 435 étant déplaçable par rapport à l'élément de support inférieur 434, par exemple en utilisant des guides 436a, 436b ; et
- optionnellement, un support 431 de substrat 410.

Le film adhésif 432 peut ainsi être maintenu entre l'élément de support supérieur 435 et le cadre 437.

Le film adhésif 432 peut être, par exemple, un film adhésif à relâchement thermique ou à relâchement par exposition UV.

Des étapes du procédé sont décrites ci-après d'abord en lien avec la figure 4A.

Le film adhésif 432 est tendu et solidarisé au cadre 437 (par adhésion avec deux portions d'extrémités du film adhésif sur la première surface 432a dudit film), puis les puces 420 sont collées sur ladite première surface dudit film adhésif entre lesdites portions d'extrémités.

Les puces 420 peuvent être positionnées sur le film adhésif 432 au moyen d'un dispositif de manipulation de puces (pick and place), en évitant de toucher les faces des puces allant être collées par collage direct au substrat 410.

Une fois les puces 420 en position sur le film adhésif 432, il est réalisé une étape de traitement de surface desdites puces, par exemple un traitement plasma N₂ ou un traitement à l'ozone sous air. Le traitement de surface de chaque puce 420 est réalisé au moins sur une première surface 420a de ladite puce destinée à être assemblée au substrat 410.

Ensuite, il est réalisé un post-traitement des puces 420 comprenant une étape de mise en contact desdites puces avec, par exemple de trempage dans, une solution aqueuse comprenant au moins 90% d'eau, pendant au moins 30 minutes et de préférence au moins 1 heure, par exemple pendant 1 heure, suivie d'une étape de séchage desdites puces, par exemple au moyen d'un sécheur. La mise en contact avec la solution aqueuse est réalisée au moins avec les premières surfaces 420a (traitées) des puces.

Après les étapes de traitement de surface et de post-traitement des puces 420, les butées 433a, 433b peuvent être disposées sur les deux portions d'extrémités de la première surface 432a du film adhésif 432, lesdites puces 420 étant entre lesdites butées.

Le cadre 437 - avec le film adhésif 432 et les puces 420 - est retourné, puis solidarisé à l'élément de support supérieur 435, par exemple par aspiration exercée par ledit élément de support supérieur sur les deux portions d'extrémités du film adhésif 432, du côté de la deuxième surface 432b dudit film. De préférence, l'élément de support supérieur 435 est sensiblement horizontal lors du positionnement du cadre 437, et maintenu sensiblement horizontal ensuite, typiquement à maximum plus ou moins 1°, et préférentiellement à maximum plus ou moins 0,1°.

Le substrat 410, et en particulier une première surface 410a dudit substrat destinée à être assemblée avec les puces 420, peut être préparé pour le collage direct suivant les techniques connues de la personne du métier, par exemple sans utiliser de plasma N₂, ni d'UV-Ozone, plus généralement sans traitement de surface sous atmosphère d'azote, et sans post-traitement en solution aqueuse.

Un film de liquide 440, par exemple un film d'eau, est formé sur la première surface 410a du substrat 410, par exemple par dépôt du liquide puis centrifugation. L'épaisseur du film de liquide est par exemple comprise entre 10 et 100 µm.

Le substrat 410 est ensuite positionné sur l'élément de support inférieur 434, dans certains cas via un support 431 de substrat. De préférence, l'élément de support inférieur 434, et, le cas échéant le support 431, est sensiblement horizontal lors du positionnement du substrat 410, et maintenu sensiblement horizontal ensuite, typiquement à maximum plus ou moins 1° et préférentiellement à maximum plus ou moins 0,1°.

Ensuite, comme illustré en figure 4B, l'élément de support supérieur 435 (avec le film adhésif 432, le cadre 437 et les puces 420) est descendu de manière à ce que les puces 420 viennent en contact avec le film de liquide 440. Le cas échéant, ce positionnement correspond à poser les butées 433a, 433b sur le substrat 410.

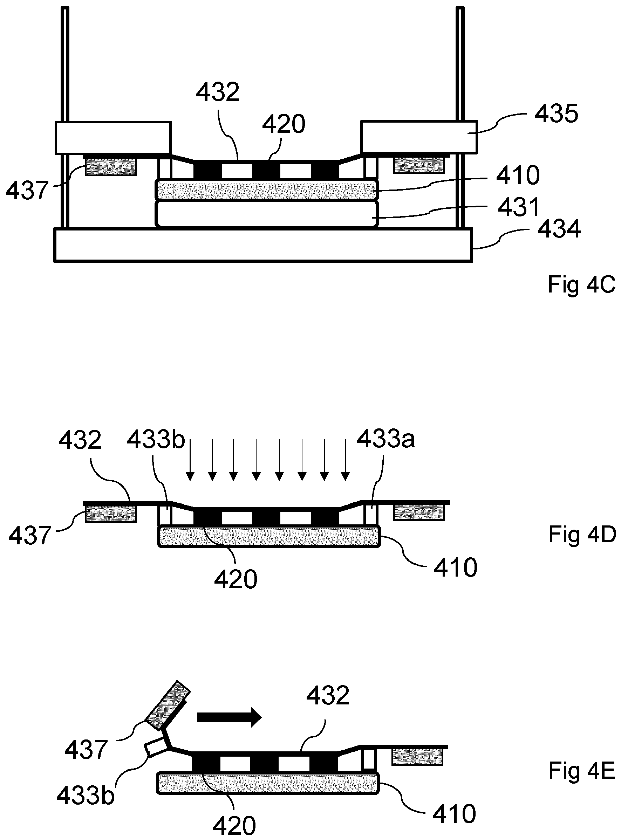

Puis le film de liquide 440 est évaporé. Dès que le temps nécessaire à l'évaporation du film de liquide est passé, comme illustré en figure 4C, le film adhésif 432 se déforme pour permettre aux puces 420 de se rapprocher du substrat 410. Les puces 420 se retrouvent alors assemblées par collage direct sur le substrat 410.

Ensuite, comme illustré en figure 4D, l'ensemble comprenant le substrat 410, les puces 420, le film adhésif 432, le cadre 437 et les butées 433a, 433b est séparé du reste du système 430. Puis le film adhésif 432 est soumis à de la chaleur ou à un rayonnement UV, de manière à le peler et le retirer.

Le cadre 437 et les butées 433a, 433b sont retirés avec le film adhésif 432, comme illustré en figure 4E.

On obtient une structure substrat-puces isolée du système 430.

De manière connue de la personne du métier, cette structure substrat-puces est alors recuite, par exemple à 200°C ou 400°C, voire plus.

Il est à présent donné un exemple particulier du deuxième mode de réalisation.

Avant d'être collées sur le film adhésif, les puces 420 sont préparées ainsi : il est mesuré l'épaisseur de trois plaques de phosphure d'indium (InP) de 50 mm de diamètre qui vont être découpées pour former les puces 420. Les épaisseurs mesurées de ces trois plaques sont toutes comprises entre 325 µm et 375 µm. Les puces 420 sont formées par découpe des trois plaques d'InP. Ces puces 420 présentent chacune, orthogonalement à leur épaisseur, un profil carré de 10 mm par 10 mm.

Le film adhésif 432 est un film adhésif sensible aux UV, par exemple un film Adwill D-650. Ledit film est tendu sur le cadre 437. Le cadre est un anneau de découpe.

Les butées 433a, 433b ont une épaisseur supérieure d'environ 50 µm à l'épaisseur des puces, par exemple comprise entre environ 375 µm et 425 µm. Elles sont par exemple en silicium.

Le dispositif de manipulation des puces 420 peut comporter : un outil pyramidal qui ne touche que les bords de chaque puce saisie, un outil formant une pince saisissant chaque puce par leurs bords latéraux, ou un outil utilisant l'effet Venturi pour saisir chaque puce.

Le traitement de surface des puces comprend un traitement UV à l'ozone (O₃) de 10 minutes pour retirer la contamination hydrocarbure des surfaces destinées à être assemblées au substrat. Le traitement peut aussi comporter un retrait de la contamination particulaire par un traitement mégasonique des puces. Ce traitement mégasonique peut être réalisé en utilisant des mégasons et une solution d'eau désionisée additionnée d'ammoniaque à 1%, par exemple avec une fréquence de 1MHz et une puissance de 1W/cm².

Le post-traitement des puces 420 comprend une étape de trempage pendant deux heures dans de l'eau désionisée dans laquelle de la soude a été diluée à une concentration massique de 10⁻⁴, suivie d'une étape de séchage au moyen d'un sécheur.

Selon l'exemple de réalisation, le traitement de surface du substrat est réalisé sans utiliser de technique plasma N₂ ou UV-Ozone, plus généralement sans traitement de surface sous atmosphère d'azote, et il n'y a pas de post-traitement du substrat par mise en contact avec une solution aqueuse.

Pour former le film de liquide 440, après dépôt du liquide sur la première surface 410a du substrat 410, une étape de centrifugation de 30 tours/minute pendant 20 secondes est mise en oeuvre pour former le film liquide 440, de sorte à ne laisser en surface du substrat 410 qu'un film de liquide d'épaisseur comprise entre environ 50 µm à 75 µm, plus largement une épaisseur compatible pour venir au contact avec les puces 420 lorsque le film adhésif 432 et le substrat 410 sont séparés par les butées 433a, 433b.

Le film de liquide 440 est un film d'eau désionisée. L'eau désionisée présente l'avantage de ne pas laisser de résidus après évaporation.

L'évaporation du film de liquide 440 est réalisée entre 30 minutes et 6 heures, par exemple 4 heures, à pression et température ambiantes sous 45% d'humidité.

Le film adhésif 432 choisi dans l'exemple de réalisation étant un film adhésif sensible aux UV, il est soumis pour son décollement à des rayonnements UV adaptés à en faciliter le pelage. Par exemple, un rayonnement UV adapté peut être de 160 mJ/cm². Après soumission aux rayonnements UV, le film adhésif est pelé pour le séparer des puces 420.

Pour le premier et/ou le deuxième mode de réalisation, et plus généralement pour un procédé de préparation ou un procédé d'assemblage selon un mode de réalisation, les variantes suivantes de la préparation peuvent être prévues, prises de manière isolée ou en combinaison :
- la solution aqueuse peut être : de l'eau désionisée ; de l'eau désionisée à laquelle une base ou un acide a été ajoutée avec une concentration inférieure à 10%, de préférence inférieure à 1%, par exemple de l'ammoniaque, ou du DEAE (Diethyleaminoethanol) pour la base, de l'acide sulfurique ou de l'acide chlorhydrique pour l'acide ; de l'eau désionisée à laquelle on a ajouté un composé amphotère, par exemple de l'eau oxygénée ;
- la mise en contact avec la solution aqueuse, par exemple le trempage dans ladite solution, est strictement supérieure à 30 minutes, par exemple supérieure à 1 heure ;
- la mise en contact avec la solution aqueuse, par exemple le trempage dans ladite solution, peut être réalisée à température ambiante ou à une température supérieure à la température ambiante, de préférence à une température inférieure à 100°C, encore plus préférentiellement inférieure à 80°C ; ceci peut être réalisé par chauffage de la solution aqueuse ;
- le séchage peut être obtenu par tout moyen de séchage adapté et connu dans les techniques de la microélectronique, les exemples donnés de séchage par centrifugation ou de séchage en utilisant un sécheur n'étant pas limitatifs.

Des détails de systèmes d'assemblage selon le premier ou le deuxième mode sont par exemple donnés dans la demande de brevet FR3105569A1.

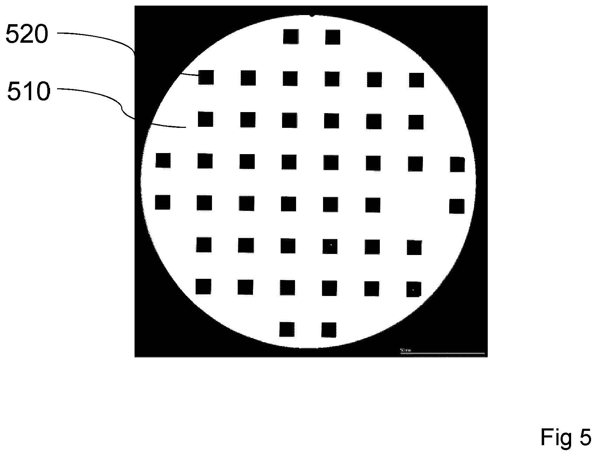

La figure 5 est une vue au microscope acoustique de puces 520 sur un substrat 510 après un procédé d'assemblage par collage direct selon un mode de réalisation, qui montre que ledit procédé permet de fortement diminuer la défectivité à l'interface de collage des puces sur le substrat après le séchage du film ou de la goutte de liquide, puisqu'on n'observe plus de points blancs sur les puces.

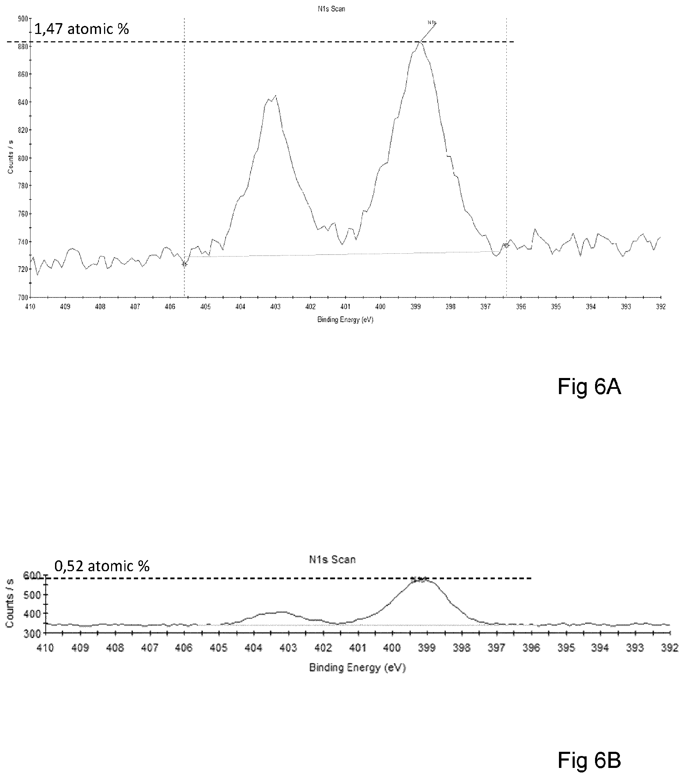

Les figures 6A et 6B représentent les résultats de mesure d'azote par spectrométrie XPS (X-Ray Photo-electron Spectroscopy) de surfaces traitées par un plasma à l'azote, l'une n'étant pas post-traitée (figure 6A), et l'autre étant post-traitée par immersion dans une solution aqueuse (figure 6B). Dans les courbes, l'azote se présente principalement sous la forme de deux pics: un pic d'azote lié au Si, qui est le plus élevé, et un pic d'azote lié au SiO₂.

Les résultats sont également donnés dans le tableau ci-dessous, correspondant au pic d'azote lié au Si :

**[Table 1]**

| Pic N1s (orbitale atomique azote) mesuré | % atomique N |
|---|---|
| Traitement plasma N₂ sans post-traitement | 1,47 |
| Traitement plasma N₂ avec post-traitement | 0,52 |

Ces résultats montrent bien l'effet du post-traitement qui permet de retirer une partie importante de l'azote implanté par le plasma en surface et en sub-surface.

Les inventeurs ont en effet déterminé que de l'azote pouvait s'implanter en surface et sub-surface, typiquement jusqu'à 3 à 4 nm sous une surface traitée par un traitement mettant en œuvre de l'azote, tel qu'un plasma N₂ ou un traitement UV-Ozone, et était lié aux défauts de collage observés après le collage direct assisté par capillarité. Le post-traitement réalisé permet de retirer une partie importante de cet azote, permettant ainsi de diminuer significativement les défauts obtenus après collage. Le retrait de l'azote introduit par un traitement plasma N₂ ou un traitement UV-Ozone avant le collage direct peut également être intéressant pour des collages directs qui ne sont pas réalisés par évaporation d'un liquide (collages directs non assistés par capillarité), par exemple pour limiter les charges mobiles qui pourraient être piégées à l'interface de collage.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, dans chacun des modes de réalisation, le substrat peut être préparé soit suivant un procédé de préparation similaire à celui des puces, soit suivant les techniques connues de la personne du métier, par exemple sans utiliser de plasma N₂, ni d'UV-Ozone et sans post-traitement par mise en contact avec une solution aqueuse et séchage. En outre, le collage direct peut être un collage direct non assisté par capillarité.

Enfin, la mise en oeuvre pratique des modes de réalisation et variantes décrits est à la portée de la personne du métier à partir des indications fonctionnelles données ci-dessus.

## Revendications

1. Procédé de préparation d'une première surface (320a, 310a ; 420a) d'un composant électronique (320, 310 ; 420), ladite première surface étant destinée à être collée sur un autre composant électronique (310, 320 ; 410) par un collage direct et ladite première surface ayant subi préalablement un traitement de surface sous une atmosphère comprenant de l'azote, par exemple un traitement sous plasma azote ou un traitement UV à l'ozone, le procédé de préparation comprenant :
- la mise en contact de ladite première surface avec une solution aqueuse comprenant au moins 90% d'eau, pendant une durée de mise en contact supérieure ou égale à 30 minutes ; puis
- le séchage de ladite première surface.

2. Procédé de préparation selon la revendication 1, dans lequel la durée de mise en contact est strictement supérieure à 30 minutes, par exemple supérieure ou égale à 40 minutes, voire supérieure ou égale à 50 minutes.

3. Procédé de préparation selon la revendication 1 ou 2, dans lequel la solution aqueuse est de l'eau désionisée, ou une solution d'eau désionisée à laquelle une base ou un acide a été ajouté(e) avec une concentration inférieure à 10%, de préférence inférieure à 1%, ou une solution d'eau désionisée à laquelle un composé amphotère a été ajouté, par exemple de l'eau oxygénée.

4. Procédé de préparation selon l'une quelconque des revendications 1 à 3, dans lequel la mise en contact avec la solution aqueuse est réalisée à une température supérieure à la température ambiante et inférieure à 100°C, de préférence inférieure à 80°C.

5. Procédé de préparation selon l'une quelconque des revendications 1 à 4, comprenant, préalablement à l'étape de mise en contact avec la solution aqueuse, une étape de traitement de la première surface (320a, 310a ; 420a) sous une atmosphère comprenant de l'azote, par exemple avec un plasma à l'azote ou un traitement UV à l'ozone.

6. Procédé d'assemblage par collage direct d'une première surface (320a ; 420a) d'au moins un premier composant électronique (320 ; 420) et d'une première surface (310a ; 410a) d'un deuxième composant électronique (310 ; 410), le procédé d'assemblage comprenant une étape de préparation d'au moins une parmi la première surface (320a ; 420a) du au moins un premier composant électronique (320 ; 420) et la première surface (310a) du deuxième composant électronique (310) selon le procédé de préparation de l'une quelconque des revendications 1 à 5, préalablement au collage direct.

7. Procédé d'assemblage selon la revendication 6, dans lequel le collage direct est un collage direct assisté par capillarité.

8. Procédé d'assemblage selon la revendication 7, dans lequel le collage direct est obtenu par évaporation d'un liquide, de préférence de l'eau, disposé entre la première surface (320a ; 420a) du au moins un premier composant électronique (320 ; 420) et la première surface (310a ; 410a) du deuxième composant électronique (310 ; 410).

9. Procédé d'assemblage selon l'une quelconque des revendications 6 à 8, dans lequel il y a une pluralité dudit au moins un premier composant électronique, lesdits premiers composants électroniques étant des puces électroniques, et le deuxième composant étant un substrat, par exemple une plaque.

10. Procédé d'assemblage selon la revendication 9, comprenant :
- une étape de positionnement des puces (320 ; 420) sur un support (331 ; 432) de puces, ledit support étant adapté à maintenir les puces (320 ; 420) de manière individualisée en vue de leur assemblage au substrat (310 ; 410) ;
- une étape de formation d'un film de liquide (340 ; 440), par exemple un film d'eau désionisée, sur la première surface (310a ; 410a) du substrat (310 ; 410) ;
- une étape de mise en contact des puces (320 ; 420) avec le film de liquide, ladite mise en contact provoquant une attraction desdites puces vers le substrat ;
- une étape d'évaporation du film de liquide (340 ; 440) de manière à coller les puces (320 ; 420) sur le substrat (310 ; 410) par collage direct ;
l'étape de préparation comprenant la préparation, par exemple selon le procédé de préparation de l'une quelconque des revendications 1 à 5, des premières surfaces (320a ; 420a) des puces, et étant réalisée après l'étape de positionnement, et avant l'étape de mise en contact avec le film de liquide.

11. Procédé d'assemblage selon la revendication 10, dans lequel la mise en contact des puces (320 ; 420) avec le film de liquide est assurée en rapprochant le substrat (310 ; 410) et le support (331 ; 432) de puces.

12. Procédé d'assemblage selon la revendication 10 ou 11, comprenant l'utilisation d'au moins une butée (333a, 333b ; 433a, 433b) agencée entre le substrat (310 ; 410) et le support (331 ; 432) de puces pour stopper le rapprochement qui assure la mise en contact des puces (320 ; 420) avec le film de liquide (340 ; 440).

13. Procédé d'assemblage selon l'une quelconque des revendications 10 à 12, le support (331) de puces comportant des cavités (332), chaque puce (320) étant positionnée dans une cavité, la première surface (320a) de ladite puce dépassant de ladite cavité, le procédé comportant une étape de retrait des puces des cavités, ladite étape de retrait étant mise en œuvre après la mise en contact des puces avec le film de liquide (340) et avant le collage des puces sur le substrat (310).

14. Procédé d'assemblage selon l'une quelconque des revendications 10 à 13, le support de puces (432) comportant un film adhésif sur lequel les puces (420) sont collées, ledit film adhésif présentant une élasticité telle qu'il se déforme au cours de l'étape d'évaporation, le procédé comprenant, après le collage des puces sur le substrat (410), une étape de retrait du film adhésif (432).

15. Procédé d'assemblage selon la revendication 14, dans lequel l'étape de retrait du film adhésif (432) comporte une étape de chauffage dudit film adhésif ou une étape d'exposition dudit film adhésif à un rayonnement ultraviolet.
